# EUROPÄISCHE PATENTSCHRIFT

(11) **EP 3 545 730 B1**
(45) Veröffentlichungstag und Bekanntmachung des Hinweises auf die Patenterteilung: **11.10.2023**
(21) Anmeldenummer: 17797618.0
(22) Anmeldetag: 08.11.2017
(51) Int. Cl.: H05K 5/00

(54) **TRÄGERBAUTEIL, INSBESONDERE EINES AUTOMOTIVE-STEUERGERÄTS**
SUPPORT COMPONENT, IN PARTICULAR OF AN AUTOMOTIVE CONTROL DEVICE
ÉLÉMENT PORTEUR, EN PARTICULIER D'UN MODULE DE COMMANDE AUTOMOBILE

(30) Priorität: 23.11.2016 DE 102016223167
(43) Veröffentlichungstag der Anmeldung: 02.10.2019
(73) Patentinhaber: Robert Bosch GmbH, 70442 Stuttgart (DE)
(72) Erfinder: MOELLER, Markus, 72793 Pfullingen (DE); SLAVOV, Geo, 72760 Reutlingen (DE); GESELLMANN, Matthias, 72770 Reutlingen (DE); KRECAR, Dragan, 72127 Kusterdingen-Wankheim (DE); SCHENK, Robert, 71665 Vaihingen/Enz (DE)
(86) Internationale Anmeldenummer: PCT/EP2017/078615
(87) Internationale Veröffentlichungsnummer: WO 2018/095735

(56) Entgegenhaltungen:
- WO-A1-2008/099009
- WO-A1-2011/157634
- DE-A1- 4 330 977
- DE-A1- 10 340 974
- DE-A1-102010 033 908
- DE-A1-102013 201 424

## Beschreibung

### Stand der Technik

Die vorliegende Erfindung betrifft ein Trägerbauteil, insbesondere ein Gehäusebauteil oder dgl., eines Automotive-Steuergeräts mit einer verbesserten Abdichtung, sowie ein derartiges Steuergerät und ein Herstellungsverfahren.

In Automotive-Steuergeräten oder dgl. werden Trägerbauteile verwendet, welche üblicherweise kupferbasierte Einlegeteile aufweisen, die mit einem Kunststoff umspritzt werden. Die Einlegeteile werden dabei zur Herstellung einer elektrischen Verbindung eines im Inneren des Steuergeräts angeordneten Elektronikbauteils mit der Außenwelt, beispielsweise einem elektrischen Anschluss, verwendet. Da das Einlegebauteil aus dem Trägerbauteil herausgeführt ist, besteht nun insbesondere bei einem Temperaturwechsel, beispielsweise einer schlagartigen Abkühlung, die Gefahr, dass im Inneren des Steuergeräts ein Unterdruck herrscht. Durch diesen Unterdruck besteht die Gefahr, dass ein an der Außenseite des Steuergeräts anliegendes Schadmedium, wie beispielsweise salzhaltiges Wasser oder eine andere Flüssigkeit, entlang der Einlegeteile in das Innere des Steuergeräts gelangt. Es wurde festgestellt, dass dies möglich ist, da durch das Kunststoffumspritzen eine schlechte bis mangelhafte Haftung des umspritzten Kunststoffs auf dem Einlegeteil auftritt, so dass zwischen dem Einlegeteil und dem Kunststoff Minimalspalte vorhanden sein können. Somit besteht die Gefahr, dass eine Lebensdauer eines Automotiv-Steuergeräts stark reduziert werden kann, insbesondere wenn aggressive Medien über diese Minimalspalte entlang des Einlegeteils hineingesaugt werden. Aus der DE 10340974 A1 ist eine Steuergeräteeinheit bekannt, welche ein Dichtgel zur Abdichtung an einer Leiterbahn vorschlägt. In Verbindung mit einem stempelartigen Deckel wird ein mediendichter Verschluss der Steuergeräteeinheit erreicht, wobei das Dichtgel zwischen dem Deckel und einer Bodenplatte abdichtet. Diese Abdichtung hat sich grundsätzlich bewährt, ist jedoch relativ aufwendig und teuer in der Herstellung. Ferner ist es bei der Herstellung relativ schwierig, die exakte Gelmenge für den Hohlraum zwischen dem Deckel und der Bodenplatte zu bestimmen. Falls die Gelmenge zu gering ist, besteht die Gefahr einer nicht sicheren Abdichtung durch das Gel. Falls die Gelmenge zu groß ist, besteht die Gefahr einer Beschädigung der Steuergeräteeinheit, da beim Aufsetzen des Deckels das Gel verdrängt wird.

Ein Trägerbauteil gemäß dem Oberbegriff des Anspruchs 1 ist aus der WO 2011/157634 A1 bekannt. Weitere Trägerbauteile eines Steuergeräts sind aus der DE 10 2013 201 424 A1, der DE 43 30 977 A1, der DE 10 2010 033 908 A1 und der WO 2008/099009 A1 bekannt.

### Offenbarung der Erfindung

Das erfindungsgemäße Trägerbauteil, insbesondere Gehäuseteil eines Automotive-Steuergeräts, mit den Merkmalen des Anspruchs 2 weist demgegenüber den Vorteil auf, dass eine kostengünstige und einfach zu realisierende und sichere mediendichte Abdichtung des Trägerbauteils an Einlegeteilen, welche teilweise von einem Material eines Spritzgusskörpers - nachfolgend als Körper bezeichnet - des Trägerbauteils umschlossen sind, ermöglicht wird. Dies wird erfindungsgemäß dadurch erreicht, dass das Trägerbauteil einen Körper mit einer Durchgangsöffnung, einer ersten Außenseite und einer zweiten Außenseite aufweist. Im Körper ist ein Einlegeteil angeordnet, welches nur teilweise vom Material des Körpers umschlossen ist. Das Einlegeteil verläuft durch die Durchgangsöffnung quer zu einer Öffnungsrichtung der Durchgangsöffnung. In der Durchgangsöffnung ist das Einlegeteil nicht von dem Material des Körpers des Trägerbauteils umschlossen. Dabei ist ein Teilbereich des Einlegeteils derart in der Durchgangsöffnung angeordnet, dass eine Oberseite des Einlegeteils einen ersten Abstand zur ersten Außenseite des Körpers aufweist und eine Unterseite des Einlegeteils einen zweiten Abstand zur zweiten Außenseite des Körpers aufweist. Das Trägerbauteil umfasst ferner ein erstes Abdichtelement, welches in der Durchgangsöffnung angeordnet ist und direkt mit dem Einlegeteil in Kontakt ist und ein zweites Abdichtelement, welches in der Durchgangsöffnung angeordnet ist und ebenfalls direkt mit dem Einlegeteil in Kontakt ist. Dabei berühren sich das erste und zweite Abdichtelement in der Durchgangsöffnung und das Einlegeteil ist vom ersten und zweiten Abdichtelement vollständig umschlossen. Somit kann das Einlegeteil in der Durchgangsöffnung durch das erste und zweite Abdichtelement hermetisch abgedichtet werden. Dadurch kann verhindert werden, dass Schadflüssigkeiten, wie z.B. Salzwasser oder dgl., entlang des Einlegeteils in das Innere des Trägerbauteils kriechen kann oder bei Auftreten eines Unterdrucks in das Innere eines Steuergeräts oder dgl. hineingezogen werden kann. Dies verlängert die Lebensdauer von Geräten, insbesondere von Automotive-Steuergeräten, in welchen das erfindungsgemäße Trägerbauteil eingebaut ist, in signifikanter Weise. Die Verwendung von zwei unterschiedlichen Abdichtelementen ermöglicht dabei eine besonders kostengünstige Herstellung, welche die hermetische Abdichtung des Einlegeteils in der Durchgangsöffnung sicherstellen kann.

Das erste Material des ersten Abdichtelements weist dabei eine höhere Viskosität auf, als das zweite Material des zweiten Abdichtelements. Durch diese unterschiedlichen Eigenschaften der Viskosität der beiden Materialien der Abdichtelemente wird bei der Herstellung der Abdichtung zuerst eine erste Abdichtmasse in die Durchgangsöffnung eingegeben, welche die Durchgangsöffnung teilweise ausfüllt und wird in einem zweiten Schritt anschließend die zweite Abdichtmasse in den verbleibenden freien Raum in der Durchgangsöffnung eingebracht. Durch die geringere Viskosität der zweiten Abdichtmasse wird sichergestellt, dass diese leicht in die vorhandenen Freiräume fließen kann und so einen engen Kontakt zur ersten Abdichtmasse und zum Einlegeteil bereitstellt. Die hohe Viskosität des ersten Materials ermöglicht ein sicheres Platzieren des ersten Abdichtelements in der Durchgangsöffnung. Die Viskosität wird dabei vor einem Aushärten der Materialien bestimmt.

Die Unteransprüche zeigen bevorzugte Weiterbildungen der Erfindung.

Bevorzugt weist die Durchgangsöffnung eine Stufe auf, an welcher das erste Abdichtelement anliegt. Durch das Vorstehen der Stufe wird ein Einbringen des ersten Abdichtelements in die Durchgangsöffnung deutlich erleichtert, da sich das Abdichtelement auch an der Stufe abstützen kann. Somit wird im ersten Schritt der Herstellung des Trägerbauteils das erste Material des ersten Abdichtelements so eingebracht, dass dieses sowohl das Einlegeteil als auch die Stufe kontaktiert. Dies stellt eine sichere Platzierung des ersten Abdichtelements sicher. Besonders bevorzugt ist die Stufe vollständig umlaufend um den Umfang der Durchgangsöffnung vorgesehen. Somit hat das erste Abdichtelement entlang des Umfangs der Durchgangsöffnung überall eine Abstützfläche durch die Stufe, so dass ein verbleibender Freiraum zwischen der Stufe und dem Einlegeteil relativ klein ist, so dass keine Gefahr besteht, dass das erste Material des ersten Abdichtelements beim Einbringen in die Durchgangsöffnung in den Zwischenraum zwischen der Durchgangsöffnung und dem Einlegeteil läuft. Hierbei ist insbesondere die hohe Viskosität des ersten Materials hilfreich.

Das Einlegeteil weist weiter bevorzugt einen viereckigen, insbesondere rechteckigen Querschnitt auf. Hierbei ist vorzugsweise das erste Abdichtelement mit einer ersten Flachseite des Einlegeteils vollständig in Kontakt und/oder das zweite Abdichtelement ist mit einer zweiten, dritten und vierten Flachseite des Einlegeteils vollständig in Kontakt. Bevorzugt kontaktiert das erste Abdichtelement nur die erste Flachseite des Einlegeteils und das zweite Abdichtelement kontaktiert die zweite, dritte und vierte Flachseite des Einlegeteils. Durch die Unterteilung der Abdichtung in zwei Abdichtelemente kann somit insbesondere bei einem viereckigen Querschnitt des Einlegeteils insbesondere an den Ecken des Einlegeteils eine sichere Abdichtung erreicht werden. Es sei angemerkt, dass es auch möglich ist, dass das erste Abdichtelement mehr als nur die erste Flachseite des Einlegeteils kontaktiert, beispielsweise teilweise Teilbereiche der dritten und vierten Flachseiten, insbesondere Schmalseiten, des Einlegeteils und das zweite Abdichtelement kontaktiert die verbleibenden Teilbereiche der dritten und vierten Flachseiten sowie die zweite Flachseite, welche der ersten Flachseite gegenüberliegt.

Weiter bevorzugt ist das Einlegeteil mittig in der Durchgangsöffnung angeordnet. Das heißt, ein erster Abstand des Einlegeteils zur ersten Außenseite ist gleich einem zweiten Abstand des Einlegeteils zur zweiten Außenseite.

Weiter bevorzugt ist das Einlegeteil aus dem Körper herausgeführt. Das Einlegeteil ist besonders bevorzugt eine elektrische Leiterbahn oder dgl. Weiter bevorzugt weist das Einlegeteil an dem aus dem Körper herausgeführten Bereich einen elektrischen Anschlussbereich oder dgl. für eine elektrische Kontaktierung auf.

Gemäß einer besonders bevorzugten Ausgestaltung der Erfindung umfasst das Einlegeteil Kupfer oder ist vollständig aus Kupfer hergestellt und das erste Material des ersten Abdichtelements und das zweite Material des zweiten Abdichtelements umfassen jeweils Silikon. Diese Materialkombination hat den besonderen Vorteil, dass Kupferoxid, welches am äußeren Umfang des Einlegeteils vorhanden ist, mit dem Silikon des ersten und zweiten Materials der Abdichtelemente eine chemische Verbindung eingeht. Somit ergibt sich eine stoffschlüssige Verbindung zwischen dem Einlegeteil und den beiden Abdichtelementen. Dies stellt die hermetische Abdichtung des Einlegeteils durch die Abdichtelemente sicher.

Der Körper des Trägerbauteils ist ein Spritzgusskörper, welcher aus einem Kunststoffmaterial hergestellt ist. Der Spritzgusskörper wird durch Spritzgießen hergestellt, wobei das Einlegeteil vor dem Spritzgießen in eine entsprechende Gussform eingelegt wird.

Gemäß einer weiteren bevorzugten Ausgestaltung der Erfindung umfasst das Trägerbauteil ein erstes und zweites Einlegeteil, wobei jeweils Teilbereiche des ersten und zweiten Einlegeteils in einer gemeinsamen Durchgangsöffnung angeordnet sind. Dies hat insbesondere fertigungstechnische Vorteile, wenn eine Vielzahl von Einlegeteilen in einer Durchgangsöffnung angeordnet sind. Vorzugsweise sind alle Einlegeteile, welche aus dem Trägerbauteil zur Außenseite herausgeführt werden, in einer gemeinsamen Durchgangsöffnung im Körper angeordnet. Hierdurch muss nur ein Mal eine Abdichtung der Einlegeteile in der Durchgangsöffnung vorgesehen werden.

Weiter bevorzugt sind bei einer Anordnung von zwei oder mehreren Einlegeteilen in einer gemeinsamen Durchgangsöffnung die Einlegeteile auf einer gleichen Ebene oder auf einer unterschiedlichen Ebene angeordnet.

Grundsätzlich ist das Trägerbauteil nach dem erfindungsgemäßen Verfahren hergestellt, welche noch nachfolgend detailliert beschrieben wird.

Die Erfindung betrifft ferner ein Steuergerät, welches ein erfindungsgemäßes Trägerbauteil umfasst. Besonders bevorzugt ist das Steuergerät, welches ein erfindungsgemäßes Trägerbauteil umfasst ein Automotive-Steuergerät.

Ferner betrifft die vorliegende Erfindung ein Verfahren zur Herstellung des erfindungsgemäßen Trägerbauteils. Das Verfahren umfasst dabei die Schritte des Einlegens eines Einlegeteils in eine Spritzgussform, das teilweise Umspritzen des Einlegeteils zur Herstellung eines Spritzgusskörpers, wobei ein Teilbereich des Einlegeteils in einer Durchgangsöffnung freiliegend verbleibt, d.h., nicht umspritzt wird. In einem nächsten Schritt erfolgt ein Einbringen eines ersten Materials für ein erstes Abdichtelement in die Durchgangsöffnung, so dass ein erster Teilbereich des Einlegeteils von dem ersten Abdichtmaterial überdeckt ist und die Durchgangsöffnung nicht vollständig durch das erste Abdichtmaterial aufgefüllt ist. In einem nächsten Schritt erfolgt dann ein Einbringen eines zweiten Abdichtmaterials in die Durchgangsöffnung in das verbliebene Restvolumen der Durchgangsöffnung, wobei das zweite Abdichtmaterial ein zweites Abdichtelement bildet, welches den noch nicht überdeckten Teilbereich des Einlegeteils überdeckt. Das erste Abdichtmaterial und das zweite Abdichtmaterial umschließen das Einlegeteil in der Durchgangsöffnung vollständig, wobei jeweils ein Teilbereich des Umfangs des Einlegeteils durch das erste Abdichtmaterial und ein restlicher Teilbereich durch das zweite Abdichtmaterial überdeckt ist.

Vorzugsweise kann beim Verfahren nach dem Einbringen des ersten Abdichtmaterials ein Schritt des Aushärtens des ersten Abdichtmaterials erfolgen. Nach Einbringen des zweiten Abdichtmaterials erfolgt ein weiterer Schritt des Aushärtens des zweiten Abdichtmaterials Das Aushärten des ersten und zweiten Abdichtmaterials kann auch gleichzeitig erfolgen.

Erfindungsgemäß ist dabei eine Viskosität des ersten und zweiten Abdichtmaterials unterschiedlich, wobei das erste Abdichtmaterial eine höhere Viskosität als das zweite Abdichtmaterial aufweist. Insbesondere ist das erste Abdichtmaterial zähflüssig. Das zweite Abdichtmaterial ist vor dem Aushärten gut fließfähig.

Vorzugsweise ist die dynamische Viskosität des ersten höherviskosen Abdichtmaterials bei 20°C in einem Bereich von 160 bis 200 Pa*s und beträgt insbesondere 180 Pa*s. Weiter bevorzugt liegt die dynamische Viskosität des zweiten niedrigviskosen Abdichtmaterials bei 20°C in einem Bereich von 0,1 bis 2 Pa*s und beträgt bevorzugt 1 Pa*s.

### Zeichnung

Nachfolgend werden unter Bezugnahme auf die begleitende Zeichnung bevorzugte Ausführungsbeispiele der Erfindung im Detail beschrieben. In der Zeichnung sind jeweils gleiche bzw. funktional gleiche Teile mit den gleichen Bezugszeichen bezeichnet. In der Zeichnung ist:
- Figur 1: eine schematische Schnittansicht eines Teilbereichs eines Trägerbauteils gemäß einem ersten bevorzugten Ausführungsbeispiel der Erfindung,
- Figur 2: eine schematische Draufsicht auf einen Teilbereich des Trägerbauteils von Figur 1,
- Figur 3: eine schematische Teilansicht des Trägerbauteils ohne Abdichtelemente von einer ersten Seite,
- Figur 4: eine schematische Teilansicht des Trägerbauteils ohne Abdichtelemente von einer zweiten Seite,
- Figur 5: eine schematische Darstellung zur Verdeutlichung des erfindungsgemäßen Verfahrens, und
- Figur 6: eine schematische Schnittansicht eines Trägerbauteils gemäß einem zweiten Ausführungsbeispiel der Erfindung.

### Bevorzugte Ausführungsformen der Erfindung

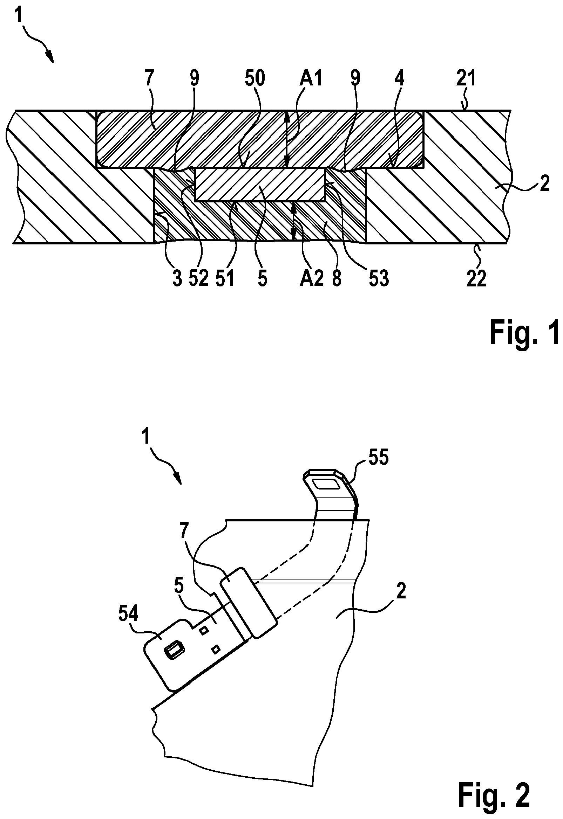

Figur 1 zeigt schematisch im Schnitt ein Trägerbauteil 1 gemäß einem ersten bevorzugten Ausführungsbeispiel der Erfindung. Das Trägerbauteil ist Teil eines Gehäuses eines Automotive-Steuergeräts.

Das Trägerbauteil 1 umfasst einen Körper 2, welcher ein Spritzgusskörper ist. Im Körper 2 ist eine Durchgangsöffnung 3 ausgebildet. Der Körper 2 weist eine erste Außenseite 21 und eine zweite Außenseite 22 auf. Die erste und zweite Außenseite sind dabei im Wesentlichen parallel zueinander.

Das Trägerbauteil 1 umfasst ferner ein Einlegeteil 5, welches in diesem Ausführungsbeispiel einen rechteckigen Querschnitt aufweist. Das Einlegeteil 5 ist ein Teil zur Stromführung ist vorzugsweise vollständig aus Kupfer hergestellt.

Wie insbesondere aus den Figuren 2 bis 4 ersichtlich ist, verläuft das Einlegeteil 5 durch die Durchgangsöffnung 3. Hierbei verläuft das Einlegeteil 5 quer zu einer Öffnungsrichtung der Durchgangsöffnung 3.

Wie aus Figur 2 ersichtlich ist, ist das Einlegeteil 5 im Körper 2 derart angeordnet, dass das Einlegeteil 5 aus dem Körper herausgeführt ist. Das Einlegeteil 5 weist in diesem Ausführungsbeispiel einen ersten Anschlussbereich 54, welcher im Inneren des Trägerbauteils liegt, und einen zweiten Anschlussbereich 55 auf, welcher aus dem Körper 2 herausgeführt ist. Der zweite Anschlussbereich 55 dient beispielsweise zur elektrischen Kontaktierung, so dass über das Einlegeteil 5 eine Stromversorgung von Elektronikbauteilen, welche elektrisch mit dem ersten Anschluss 54 verbunden sind, ermöglicht werden.

Somit das Einlegeteil 5 nur teilweise vom Material des Körpers 2, üblicherweise ein Kunststoffmaterial, umschlossen.

Wie weiter aus Figur 1 ersichtlich ist, ist das Einlegeteil 5 derart in der Durchgangsöffnung 3 angeordnet, dass eine Oberseite 50 des Einlegeteils 5 mit einem ersten Abstand A1 zur ersten Außenseite 21 angeordnet ist. Eine Unterseite 51 des Einlegeteils 5 ist mit einem zweiten Abstand A2 zur zweiten Außenseite 22 des Körpers 2 angeordnet. In diesem Ausführungsbeispiel sind der erste Abstand A1 und der zweite Abstand A2 unterschiedlich gewählt, es ist jedoch auch möglich, dass die Abstände gleich groß sind.

Das Trägerbauteil 1 umfasst ferner ein erstes Abdichtelement aus einem ersten Material und ein zweites Abdichtelement aus einem zweiten Material. Die beiden Materialien der Abdichtelemente sind dabei unterschiedlich. Das erste Abdichtelement 7 ist in der Durchgangsöffnung 3 angeordnet und befindet sich direkt mit dem Einlegeteil 5 in Kontakt. Das zweite Abdichtelement 8 ist ebenfalls in der Durchgangsöffnung 3 angeordnet und befindet sich ebenfalls mit dem Einlegeteil 5 in Kontakt. Somit füllen die beiden Abdichtelemente 7, 8 sowie das Einlegeteil 5 die Durchgangsöffnung 3 vollständig aus, wie in Figur 1 gezeigt.

Wie weiter in Figur 1 gezeigt ist, umschließen das erste Abdichtelement 7 und das zweite Abdichtelement 8 das Einlegeteil 5 in Umfangsrichtung des Einlegeteils vollständig. Da das Einlegeteil 5 mit seitlichem Abstand zur Durchgangsöffnung 3 angeordnet ist, ergibt sich ferner ein Kontaktbereich 9 zwischen dem ersten Abdichtelement 7 und dem zweiten Abdichtelement 8. Somit umschließen das erste Abdichtelement 7 und das zweite Abdichtelement 8 zusammen gemeinsam das Einlegeteil 5, wobei jeweils ein Teilbereich des Einlegeteils in Umfangsrichtung durch die Abdichtelemente 7, 8 umschlossen ist.

Das erste und zweite Abdichtelement 7, 8 ist dabei, wie erwähnt, aus jeweils unterschiedlichem Material hergestellt. Hierbei weisen das erste und zweite Material für das erste und zweite Abdichtelement jeweils einen Silikonanteil auf.

Ferner weisen die beiden Materialien der Abdichtelemente 7, 8 unterschiedliche Viskositäten auf. Dabei ist das erste Material des ersten Abdichtelements 7 derart gewählt, dass es eine hohe Viskosität aufweist und das zweite Material des zweiten Abdichtelements 8 weist eine niedrigere Viskosität als die des ersten Materials auf. Dies ist insbesondere für den Herstellungsprozess wichtig, da durch die Wahl der Materialien für die Abdichtelemente 7, 8 mit unterschiedlichen Viskositäten eine Herstellung signifikant erleichtert werden kann. Die Viskosität ist dabei vor dem Einbringen in die Durchgangsöffnung bestimmt.

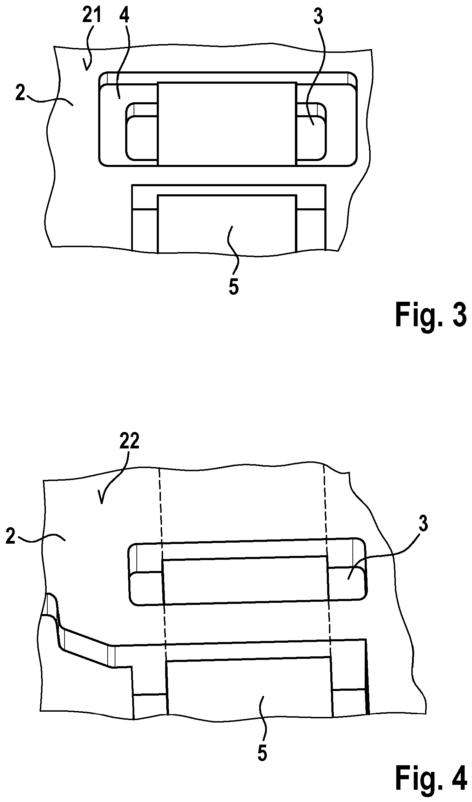

Wie weiter aus Figur 1 ersichtlich ist, weist die Durchgangsöffnung 3 eine Stufe 4 auf. Wie in den Figuren 3 und 4 gezeigt, ist die Stufe 4 umlaufend um den Außenumfang der Durchgangsöffnung 3 vorgesehen. Die Stufe 4 dient hierbei während der Herstellung des Trägerbauteils als unterstützender Bereich, um die Materialmasse für das erste Abdichtelement 7 an einer vorbestimmten Position zu halten. Insbesondere wird durch die Stufe 4 vermieden, dass das erste Material des ersten Abdichtelements 7 in den Zwischenbereich zwischen dem Einlegeteil 5 und der Wand der Durchgangsöffnung 3 gelangt.

Somit kontaktiert das erste Abdichtelement 7 das Einlegeteil 5 vollständig an der Oberseite 50 (erste Flachseite) und das zweite Abdichtelement 8 kontaktiert die Unterseite 51 (zweite Flachseite), eine seitliche dritte Flachseite 52 und eine seitliche vierte Flachseite 53 vollständig. Somit kann eine hermetische Abdichtung zwischen dem Einlegeteil 5 und den beiden Abdichtelementen 7, 8 ermöglicht werden.

Da ferner am Einlegeteil 5 an dessen Außenseite Kupferoxid vorhanden ist, und das erste und zweite Material der beiden Abdichtelemente 7, 8 jeweils Silikon umfasst, ergibt sich der weitere Vorteil einer chemischen Verbindung zwischen den Silikonbestandteilen der Abdichtelemente 7, 8 und dem Kupferoxid. Somit kann eine stoffschlüssige Verbindung zwischen den beiden Abdichtelemente 7, 8 und dem Einlegeteil 5 erreicht werden, wodurch die hermetische Abdichtung sichergestellt werden kann.

Wie insbesondere aus Figur 1 und 2 ersichtlich ist, sind das erste Abdichtelement 7 und das zweite Abdichtelement derart in der Durchgangsöffnung 3 vorgesehen, dass ein bündiger Abschluss zur ersten und zweiten Außenseite 21, 22 des Spritzgusskörpers 2 ermöglicht wird.

Unter Bezugnahme auf die Figuren 3 bis 5 wird zur Herstellung des erfindungsgemäßen Trägerbauteils das erfindungsgemäße Verfahren im Detail beschrieben. In einem ersten Schritt wird das Einlegeteil 5 in eine nicht gezeigte Spritzgussform eingelegt. Anschließend erfolgt ein teilweises Umspritzen des Einlegeteils 5 zur Herstellung des Spritzgusskörpers 2, wobei ein Teilbereich des Einlegeteils 5 in einer Durchgangsöffnung 3 freiliegend verbleibt. D.h., das Einlegeteil 5 wird in der Durchgangsöffnung 3 nicht umspritzt, wie aus den Figuren 3 und 4 ersichtlich ist.

Da in diesem Ausführungsbeispiel das Einlegeteil 5 zur Stromversorgung und/oder zum Datenaustausch verwendet wird, ist das Einlegeteil 5 derart in die Spritzgussform eingelegt, dass später der zweite Anschlussbereich 55 außerhalb des Spritzgusskörpers 2 liegt.

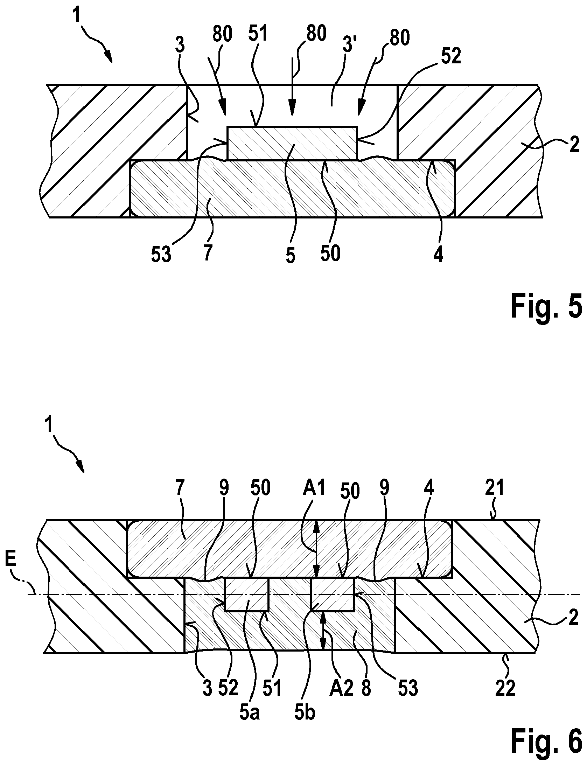

Da durch das Umspritzen des Einlegeteils 5 üblicherweise keine ausreichende Haftung des gespritzten Kunststoffes auf dem Einlegeteil 5 stattfindet und Minimalspalte dazwischen auftreten können, muss eine Abdichtung vorgesehen werden, welche erfindungsgemäß im Bereich der Durchgangsöffnung 3 vorgesehen wird. Hierbei wird ein erstes Material für ein erstes Abdichtelement 7 in einem Teilvolumen der Durchgangsöffnung eingebracht, so dass das erste Material die Durchgangsöffnung 3 verschließt und trotzdem ein zweites Teilvolumen 3' verbleibt, welches noch nicht gefüllt ist. Dieser Zustand ist in Figur 5 gezeigt.

Das erste Material für das erste Abdichtelement 7 weist eine hohe Viskosität auf, so dass vermieden wird, dass das erste Material in einen Zwischenraum zwischen dem Einlegeteil 5 und den Wandbereichen der Durchgangsöffnung 3 gelangt. Für ein einfaches Aufbringen des ersten Materials wird dieses zuerst auf der Stufe 4 aufgebracht und dann als Raupe über die Oberseite 50 des Einlegeteils 5 bis zum anderen Randbereich aufgebracht.

Vorzugsweise wird das erste Material nun ausgehärtet, um das erste Abdichtelement 7 zu bilden. Das erste Material kann jedoch auch derart ausgewählt werden, dass dieses eine sehr hohe Viskosität aufweist und erst gemeinsam mit dem zweiten Material, welches dann das zweite Abdichtelement 8 bildet, aushärtet.

Nach dem Einbringen des ersten Materials wird das zweite Material für das zweite Abdichtelement 8 eingebracht. Hierbei kann bevorzugt das Bauteil um 180° gewendet werden, wie in Figur 5 dargestellt, um dann das zweite Material in die nach oben liegende Öffnung einzubringen. Dies ist in Figur 5 durch die Pfeile 80 angedeutet.

Das zweite Material weist eine geringere Viskosität als das erste Material auf, so dass ein leichtes Fließen des zweiten Materials auch in Eckbereiche der Durchgangsöffnung 3 möglich ist. Nachdem das zweite Material das verbleibende zweite freie Teilvolumen 3` der Durchgangsöffnung verfüllt hat, erfolgt ein Aushärten des zweiten Materials. Wie oben stehend erwähnt, kann der Aushärteschritt dabei so erfolgen, dass auch gleichzeitig beide Materialien der Abdichtelemente 7, 8 in einem Schritt ausgehärtet werden können. Das Aushärten kann beispielsweise mittels UV-Bestrahlung oder Wärme oder dgl. erfolgen.

Somit wird bei der erfindungsgemäßen Idee beim Umspritzen des Einlegeteils 5 bewusst eine Durchgangsöffnung 3 freigehalten, an welcher eine Abdichtung zwischen dem Einlegeteil 5 und dem Spritzgusskörper 2 ermöglicht wird. Die Abdichtung erfolgt dabei gezielt mit zwei unterschiedlichen Abdichtmaterialien. Die beiden Abdichtmaterialien basieren bevorzugt auf Silikon, um mit dem Einlegeteil, welches bevorzugt aus Kupfer hergestellt ist, eine chemische Verbindung eingehen zu können. Hierdurch kann sicher eine hermetische Abdichtung erreicht werden. Dadurch kann eine außenstehende Flüssigkeit nicht über einen Minimalspalt zwischen dem Einlegeteil 5 und dem Spritzgussteil 2 in das Innere eines Bauteils, wie beispielsweise eines Steuergeräts oder dgl., gelangen.

Figur 6 zeigt ein Trägerbauteil gemäß einem zweiten bevorzugten Ausführungsbeispiel der Erfindung.

Wie aus Figur 6 ersichtlich ist, umfasst das Trägerbauteil des zweiten Ausführungsbeispiels zwei Einlegeteile, nämlich ein erstes Einlegeteil 5a und ein zweites Einlegeteil 5b. Die beiden Einlegeteile 5a und 5b sind gemeinsam in der Durchgangsöffnung 3 mit einem Abstand zueinander angeordnet. Wie aus Figur 6 ersichtlich ist, liegen die beiden Einlegeteile 5a, 5b hierbei auf einer gemeinsamen Ebene E, welche auch eine Mittelebene des Trägerbauteils 1 sein kann. Wie beim ersten Ausführungsbeispiel umschließen das erste Abdichtelement 7 und das zweite Abdichtelement 8 beide Einlegeteile 5a, 5b vollständig, um eine hermetische Abdichtung zu erreichen. Dabei werden die gleichen Vorteile wie beim ersten Ausführungsbeispiel erhalten. Auch ist das Verfahren zur Herstellung des Trägerbauteils wie beim ersten Ausführungsbeispiel mit dem Unterschied, dass zwei Einlegeteile eingelegt werden und nach dem Spritzgussvorgang in der Durchgangsöffnung 3 teilweise angeordnet sind.

Zu dem zweiten Ausführungsbeispiel sei ferner angemerkt, dass es auch möglich ist, dass die Einlegeteile 5a, 5b auf unterschiedlichen Ebenen innerhalb des Trägerbauteils 1 angeordnet werden können.

Weiterhin sei zu dem zweiten Ausführungsbeispiel ausgeführt, dass es besonders vorteilhaft ist, wenn alle Einlegeteile, welche eine Verbindung zwischen einer Außenseite und einer Innenseite des Trägerbauteils herstellen, also insbesondere elektrische Leitungen und/oder Datenleitungen oder dgl., durch eine gemeinsame Durchgangsöffnung 3 hindurchgeführt werden und dann gemeinsam mit dem ersten und zweiten Abdichtelement 7, 8 abgedichtet werden. Hierdurch können insbesondere die Herstellungskosten derartiger Bauteile signifikant reduziert werden.

## Patentansprüche

1. Verfahren zur Herstellung eines Trägerbauteils (1), umfassend die Schritte:
- Einlegen wenigstens eines Einlegeteils (5) in eine Spritzgussform,
- teilweises Umspritzen des Einlegeteils (5) zur Herstellung eines Spritzgusskörpers (2), wobei ein Teilbereich des Einlegeteils (5) in einer Durchgangsöffnung (3) freiliegend verbleibt, und
- Einbringen eines ersten Materials eines ersten Abdichtelements (7) in die Durchgangsöffnung (3), so dass ein erster Teilbereich des Einlegeteils (5) von dem ersten Material überdeckt ist und ein Teilvolumen (3') der Durchgangsöffnung (3) freibleibt,
**gekennzeichnet durch**
- Einbringen eines zweiten Materials eines zweiten Abdichtelements in einem fließfähigem Zustand (8) in das Teilvolumen (3') der Durchgangsöffnung (3), welches anschließend in der Durchgangsöffnung (3) aushärtet, so dass ein von dem ersten Material unüberdeckter zweiter Teilbereich des Einlegeteils (5) vollständig vom zweiten Material des zweiten Abdichtelements überdeckt wird und das Einlegeteil (5) vollständig durch das erste Material und das zweite Material umschlossen ist, wobei das erste Material des ersten Abdichtelements (7) eine höhere Viskosität vor dem Aushärten des Materials aufweist als das zweite Material des zweiten Abdichtelements (8).

2. Trägerbauteil, insbesondere Gehäusebauteil eines Steuergeräts, umfassend:
- einen Spritzgusskörper (2) mit einer Durchgangsöffnung (3), einer ersten Außenseite (21) und einer zweiten Außenseite (22),
- ein Einlegeteil (5), welches nur teilweise vom Material des Spritzgusskörpers (2) umschlossen ist und durch die Durchgangsöffnung (3) quer zur Öffnungsrichtung der Durchgangsöffnung verläuft,
- wobei das Einlegeteil derart in der Durchgangsöffnung (3) angeordnet ist, dass eine Oberseite (50) des Einlegeteils (5) einen ersten Abstand (A1) zur ersten Außenseite (21) aufweist und eine Unterseite (51) des Einlegeteils (5) einen zweiten Abstand (A2) zur zweiten Außenseite (22) aufweist,
- ein erstes Abdichtelement (7) aus einem ersten Material, welches in der Durchgangsöffnung (3) angeordnet ist und direkt mit dem Einlegeteil (5) in Kontakt ist, und
- ein zweites Abdichtelement (8) aus einem zweiten Material, welches in der Durchgangsöffnung (3) angeordnet ist und direkt mit dem Einlegeteil (5) in Kontakt ist,
**dadurch gekennzeichnet, dass** das erste Abdichtelement (7) und das zweite Abdichtelement (8) sich an einem Kontaktbereich (9) in der Durchgangsöffnung (3) kontaktieren und das Einlegeteil (5) in Umfangsrichtung des Einlegeteils vollständig umschließen, wobei das erste Material des ersten Abdichtelements (7) eine höhere Viskosität vor dem Aushärten des Materials aufweist als das zweite Material des zweiten Abdichtelements (8) und das Trägerbauteil gemäß dem Verfahren nach Anspruch 1 hergestellt ist.

3. Trägerbauteil nach Anspruch 2, wobei die Durchgangsöffnung (3) eine Stufe (4) aufweist, an welcher das erste Abdichtelement (7) anliegt.

4. Trägerbauteil nach Anspruch 3, wobei die Stufe (4) vollständig um den Umfang der Durchgangsöffnung (3) umläuft.

5. Trägerbauteil nach einem der Ansprüche 2 bis 4, wobei das Einlegeteil (5) einen viereckigen Querschnitt, insbesondere einen rechteckigen Querschnitt, aufweist.

6. Trägerbauteil nach Anspruch 5, wobei das erste Abdichtelement (7) mit einer ersten Flachseite (52) des Einlegeteils vollständig in Kontakt ist und/oder wobei das zweite Abdichtelement (8) mit einer zweiten Flachseite (53), einer dritten Flachseite (54) und einer vierten Flachseite (55) des Einlegeteils in Kontakt ist.

7. Trägerbauteil nach einem der Ansprüche 2 bis 6, wobei der erste Abstand (A1) gleich dem zweiten Abstand (A2) ist.

8. Trägerbauteil nach einem der Ansprüche 2 bis 7, wobei das Einlegeteil (5) aus dem Spritzgusskörper (2) herausgeführt ist.

9. Trägerbauteil nach einem der Ansprüche 2 bis 8, wobei das Einlegeteil (5) Kupfer umfasst oder vollständig aus Kupfer hergestellt ist und wobei das erste Material des ersten Abdichtelements (7) und das zweite Material des zweiten Abdichtelements (8) Silikon umfasst.

10. Trägerbauteil nach einem der Ansprüche 2 bis 9, umfassend wenigstens ein erstes Einlegeteil (5a) und ein zweites Einlegeteil (5b), wobei jeweils Teilbereiche der Einlegeteile (5a, 5b) in einer gemeinsamen Durchgangsöffnung (3) angeordnet sind.

11. Trägerbauteil nach Anspruch 10, wobei die Einlegeteile (5a, 5b) in einer gemeinsamen Ebene (E) angeordnet sind oder in unterschiedlichen Ebenen angeordnet sind.

12. Trägerbauteil nach einem der Ansprüche 10 oder 11, wobei alle Einlegeteile (5), welche aus dem Spritzgusskörper (2) zur Außenseite herausgeführt sind, in einer gemeinsamen Durchgangsöffnung (3) angeordnet sind.

13. Steuergerät, insbesondere Automotive-Steuergerät, umfassend ein Trägerbauteil nach einem der vorhergehenden Ansprüche 2 bis 12.

## Claims

1. Method for producing a carrier component (1), comprising the steps of:
- inserting at least one insert part (5) into an injection mould,
- partially encapsulating the insert part (5) to produce an injection-moulded body (2), wherein a sub-region of the insert part (5) remains exposed in a through-opening (3), and
- introducing a first material of a first sealing element (7) into the through-opening (3) such that a first sub-region of the insert part (5) is covered by the first material and a sub-volume (3') of the through-opening (3) remains free,
**characterized by**
- introducing a second material of a second sealing element in a flowable state (8) into the sub-volume (3') of the through-opening (3), which subsequently cures in the through-opening (3) such that a second sub-region, not covered by the first material, of the insert part (5) is completely covered by the second material of the second sealing element and the insert part (5) is completely enclosed by the first material and the second material, wherein the first material of the first sealing element (7) has a higher viscosity prior to the curing of the material than the second material of the second sealing element (8).

2. Carrier component, in particular housing component of a control device, comprising:
- an injection-moulded body (2) with a through-opening (3), with a first outer side (21) and with a second outer side (22),
- an insert part (5) which is enclosed only partially by the material of the injection-moulded body (2) and extends through the through-opening (3) transversely to the opening direction of the through-opening,
- wherein the insert part is arranged in the through-opening (3) in such a way that a top side (50) of the insert part (5) is at a first distance (A1) from the first outer side (21) and a bottom side (51) of the insert part (5) is at a second distance (A2) from the second outer side (22),
- a first sealing element (7) composed of a first material, which is arranged in the through-opening (3) and is directly in contact with the insert part (5), and
- a second sealing element (8) composed of a second material, which is arranged in the through-opening (3) and is directly in contact with the insert part (5),
**characterized in that** the first sealing element (7) and the second sealing element (8) are in contact in the through-opening (3) at a contact region (9), and completely enclose the insert part (5) in the peripheral direction of the insert part, wherein the first material of the first sealing element (7) has a higher viscosity prior to the curing of the material than the second material of the second sealing element (8) and the carrier component is produced according to the method in Claim 1.

3. Carrier component according to Claim 2, wherein the through-opening (3) has a step (4) against which the first sealing element (7) bears.

4. Carrier component according to Claim 3, wherein the step (4) runs completely around the periphery of the through-opening (3).

5. Carrier component according to one of Claims 2 to 4, wherein the insert part (5) has a quadrilateral cross section, in particular a rectangular cross section.

6. Carrier component according to Claim 5, wherein the first sealing element (7) is fully in contact with a first flat side (52) of the insert part, and/or wherein the second sealing element (8) is in contact with a second flat side (53), a third flat side (54) and a fourth flat side (55) of the insert part.

7. Carrier component according to one of Claims 2 to 6, wherein the first distance (A1) is equal to the second distance (A2).

8. Carrier component according to one of Claims 2 to 7, wherein the insert part (5) is led out of the injection-moulded body (2).

9. Carrier component according to one of Claims 2 to 8, wherein the insert part (5) comprises copper or is produced entirely from copper, and wherein the first material of the first sealing element (7) and the second material of the second sealing element (8) comprises silicone.

10. Carrier component according to one of Claims 2 to 9, comprising at least a first insert part (5a) and a second insert part (5b), wherein in each case subregions of the insert parts (5a, 5b) are arranged in a common through-opening (3).

11. Carrier component according to Claim 10, wherein the insert parts (5a, 5b) are arranged in a common plane (E) or are arranged in different planes.

12. Carrier component according to either of Claims 10 and 11, wherein all the insert parts (5) which are led out of the injection-moulded body (2) to the outer side are arranged in a common through-opening (3) .

13. Control device, in particular automotive control device, comprising a carrier component according to one of preceding Claims 2 to 12.

## Revendications

1. Procédé de fabrication d'un élément de support (1), comprenant les étapes suivantes :
- mise en place d'au moins une pièce d'insertion (5) dans un moule d'injection,
- surmoulage partiel de la pièce d'insertion (5) pour fabriquer un corps (2) moulé par injection, une zone partielle de la pièce d'insertion (5) restant exposée dans une ouverture traversante (3), et
- introduction d'un premier matériau d'un premier élément d'étanchéité (7) dans l'ouverture traversante (3), de sorte qu'une première zone partielle de la pièce d'insertion (5) est recouverte par le premier matériau et qu'un volume partiel (3') de l'ouverture traversante (3) reste libre,
**caractérisé par**
- l'introduction d'un deuxième matériau d'un deuxième élément d'étanchéité dans un état fluide (8) dans le volume partiel (3') de l'ouverture traversante (3), qui durcit ensuite dans l'ouverture traversante (3), de sorte qu'une deuxième zone partielle de la pièce d'insertion (5) non recouverte par le premier matériau est entièrement recouverte par le deuxième matériau du deuxième élément d'étanchéité et que la pièce d'insertion (5) est entièrement entourée par le premier matériau et le deuxième matériau, le premier matériau du premier élément d'étanchéité (7) présentant une viscosité plus élevée avant le durcissement du matériau que le deuxième matériau du deuxième élément d'étanchéité (8).

2. Élément de support, en particulier composant de boîtier d'un appareil de commande, comprenant :
- un corps (2) moulé par injection avec une ouverture traversante (3), une première face extérieure (21) et une deuxième face extérieure (22),
- une pièce d'insertion (5) qui n'est que partiellement entourée par le matériau du corps (2) moulé par injection et qui s'étend à travers l'ouverture traversante (3) transversalement à la direction d'ouverture de l'ouverture traversante,
- la pièce d'insertion étant disposée dans l'ouverture traversante (3) de telle sorte qu'une face supérieure (50) de la pièce d'insertion (5) présente une première distance (A1) par rapport à la première face extérieure (21) et qu'une face inférieure (51) de la pièce d'insertion (5) présente une deuxième distance (A2) par rapport à la deuxième face extérieure (22),
- un premier élément d'étanchéité (7) en un premier matériau, qui est disposé dans l'ouverture traversante (3) et est directement en contact avec la pièce d'insertion (5), et
- un deuxième élément d'étanchéité (8) en un deuxième matériau, qui est disposé dans l'ouverture traversante (3) et est directement en contact avec la pièce d'insertion (5),
**caractérisé en ce que** le premier élément d'étanchéité (7) et le deuxième élément d'étanchéité (8) sont en contact au niveau d'une zone de contact (9) dans l'ouverture traversante (3) et entourent complètement la pièce d'insertion (5) dans la direction circonférentielle de la pièce d'insertion, le premier matériau du premier élément d'étanchéité (7) ayant une viscosité plus élevée avant le durcissement du matériau que le deuxième matériau du deuxième élément d'étanchéité (8), et le composant de support étant fabriqué selon le procédé selon la revendication 1.

3. Élément de support selon la revendication 2, dans lequel l'ouverture traversante (3) présente un gradin (4) contre lequel s'appuie le premier élément d'étanchéité (7) .

4. Élément de support selon la revendication 3, dans lequel le gradin (4) fait entièrement le tour de la circonférence de l'ouverture traversante (3).

5. Élément de support selon l'une des revendications 2 à 4, dans lequel la pièce d'insertion (5) présente une section transversale quadrangulaire, notamment une section transversale rectangulaire.

6. Élément de support selon la revendication 5, dans lequel le premier élément d'étanchéité (7) est entièrement en contact avec une première face plate (52) de l'insert et/ou dans lequel le deuxième élément d'étanchéité (8) est en contact avec une deuxième face plate (53), une troisième face plate (54) et une quatrième face plate (55) de l'insert.

7. Élément de support selon l'une des revendications 2 à 6, dans lequel la première distance (A1) est égale à la deuxième distance (A2).

8. Élément de support selon l'une des revendications 2 à 7, dans laquelle la pièce d'insertion (5) est sortie du corps (2) moulé par injection.

9. Élément de support selon l'une des revendications 2 à 8, dans laquelle la pièce d'insertion (5) comprend du cuivre ou est entièrement réalisée en cuivre, et dans laquelle le premier matériau du premier élément d'étanchéité (7) et le deuxième matériau du deuxième élément d'étanchéité (8) comprennent du silicone.

10. Élément de support selon l'une des revendications 2 à 9, comprenant au moins une première pièce d'insertion (5a) et une deuxième pièce d'insertion (5b), des zones partielles des pièces d'insertion (5a, 5b) étant respectivement disposées dans une ouverture traversante (3) commune.

11. Élément de support selon la revendication 10, dans lequel les pièces d'insertion (5a, 5b) sont disposées dans un plan commun (E) ou dans des plans différents.

12. Élément de support selon l'une des revendications 10 ou 11, dans lequel toutes les pièces d'insertion (5) qui sortent du corps (2) moulé par injection vers la face extérieure sont disposées dans une ouverture traversante (3) commune.

13. Appareil de commande, en particulier appareil de commande automobile, comprenant un élément de support selon l'une des revendications 2 à 12 précédentes.
